# EUROPEAN PATENT SPECIFICATION

(11) **EP 1 622 182 B1**
(45) Date of publication and mention of the grant of the patent: **21.03.2007**
(21) Application number: 04017894.9
(22) Date of filing: 28.07.2004
(51) Int. Cl.: H01J 27/26, H01J 37/08

(54) **Emitter for an ion source and method of producing same**
Emitter für eine Ionenquelle und Verfahren zur dessen Herstellung
Emetteur pour source de ions et procédé pour sa production

(43) Date of publication of application: 01.02.2006
(73) Proprietor: ICT Integrated Circuit Testing Gesellschaft für Halbleiterprüftechnik mbH, 85551 Heimstetten (DE)
(72) Inventor: Pilz, Wolfgang, 01324 Dresden (DE); Bischoff, Lothar, 01309 Dresden (DE)
(74) Representative: Zimmermann, Gerd Heinrich

(56) References cited:
- EP-A- 0 620 582
- US-A- 4 488 045
- CHAO L C ET AL: "Rare earth focused ion beam implantation utilizing Er and Pr liquid alloy ion sources" JOURNAL OF VACUUM SCIENCE & TECHNOLOGY B: MICROELECTRONICS PROCESSING AND PHENOMENA, AMERICAN VACUUM SOCIETY, NEW YORK, NY, US, vol. 17, no. 6, November 1999 (1999-11), pages 2791-2794, XP012007819 ISSN: 0734-211X
- MACHALETT F ET AL: "Investigations on liquid alloy ion sources for rare-earth elementsa)" REVIEW OF SCIENTIFIC INSTRUMENTS, AMERICAN INSTITUTE OF PHYSICS, US, vol. 69, no. 3, March 1998 (1998-03), pages 1336-1339, XP012036455 ISSN: 0034-6748
- CHENG X Q ET AL: "Fabrication of PrSi2 layers and associated morphology on Si surface by a single-step high current Pr-ion implantation" JOURNAL OF ALLOYS AND COMPOUNDS, ELSEVIER SEQUOIA, LAUSANNE, CH, vol. 345, no. 1-2, 28 October 2002 (2002-10-28), pages 252-256, XP004388174 ISSN: 0925-8388

## Description

### FIELD OF THE INVENTION

The invention relates to an emitter for an ion source and, particularly, an emitter for a liquid metal alloy ion source (LMAIS). The invention relates further to a method of producing such an emitter.

### BACKGROUND OF THE INVENTION

Focused ion beam (FIB) technology is an important tool for the semiconductor industry. Focused ion beams are used for failure analysis, transmission electron microscopy specimen preparation, and circuit and mask modification. FIB micro and nanofabrication can be utilized to reduce the complexity required in conventional fabrication technology, in particular lithography, etching and implantation, which has to satisfy various requirements for different components fabricated on the same substrate.

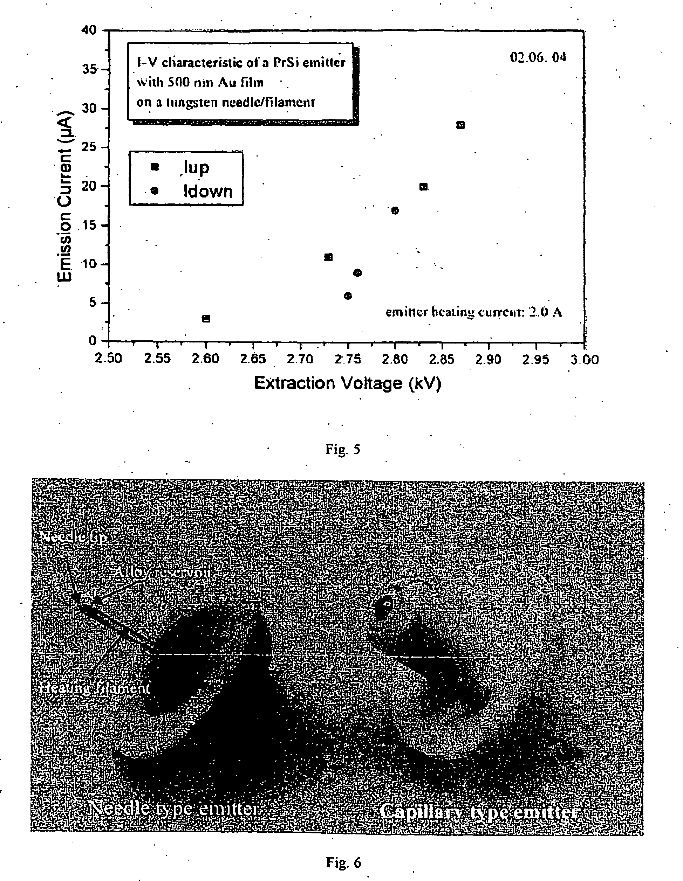

The success of FIB technology is due to the invention of liquid metal ion sources (LMIS). In a LMIS, a tiny hairpin and a filament, typically made of W, Ta, Ti or Ni, are used as an emitter (see left-hand side of Fig. 6). Also, reservoir type emitters with and without hairpin and porous emitters are known. An emitter of the capillary type is shown on the right hand side of Fig. 6.

The emitter is wetted and loaded with a source material. For wetting as well as during operation of the source, the source material must be provided in liquid form. To this end, a resistance heater or an electron beam heater may be used. High voltage is then applied between the emitter tip and a counter electrode. Due to the high electric field strength at the emitter tip, an even smaller tip of liquid source material forms at the emitter tip and ions are emitted therefrom. Thereby, a stable ion beam is generated from the source material.

However, the source material has to fulfill several physical and chemical requirements. It is important that the source material is metallic, has a relatively low melting point and a low vapour pressure. However, it is of special importance that the source material has good wetting properties with respect to the material of the filament.

Rare earth metals are widely used for laser and optical communications applications. Among the rare earths, praseodymium (Pr) has drawn a lot of interest because of the emission at 1.3 µm which corresponds to a wavelength for minima in absorption and dispersion in silica optical fibers. Furthermore, Pr is used in Si or GaAs semiconductors. Particularly, DE 100 39 327 A1 describes the use of Pr₂O₃ as a gate oxide in MOSFETs for further reduction of the gate length. Also, implantation of Pr ion in high-T_{c} superconductors for the formation of Josephson junctions is reported in "Praseodymium alloy ion source for focused ion beam implantation in superconductors" by F. Machalett et al., Rev. Sci. Instrum. 67 (3), 1996.

However, S. Papadopoulos reports in "A study of the liquid Pr-ion source", Phys. D, 20 (1987), p. 1302, a poor wettability of tungsten by liquid Pr at temperatures near the melting point. Also, when exposed to air the liquid Pr rapidly oxidizes to Pr₂O₃, one of the most refractory substances known.

Therefore, the authors of "Praseodymium alloy ion source for focused ion beam implantation in superconductors", Rev. Sci. Instrum. 67 (3), 1996, used the ternary alloy Au-Si-Pr as a source material. However, Au is an improper source material for semiconductor industry: Due to its rapid diffusion Au quickly disperses within the semiconductor material and alters the conductivity in an uncontrollable manner.

In "Rare earth focused ion beam implantation utilizing Er and Pr liquid alloy ion sources" by L.C. Chao et al., J. Vac. Sci. Technol. B 17(6), Nov/Dec 1999, a LMAIS with the binary alloys PrPt and PrAg on a tungsten wire is described. However, also these source materials will introduce Pt or Ag impurities into the semiconductor material.

Finally, EP 0 620 582 describes the use of the binary alloy CoPr for a Co ion source. However, the Pr is only used to lower the melting point in this application.

It is therefore an object of the present invention to overcome at least in part the disadvantages associated with the prior art.

### SUMMARY OF THE INVENTION

This object is solved by an emitter according to claim 1 and a manufacturing method according to claim 14.

Further advantages, features, aspects and details of the invention are evident from the dependent claims, the description and the accompanying drawings.

According to a first aspect of the present invenion, an emitter for an ion source is provided, wherein said emitter comprises the binary alloy PrSi as a source material. Thus, only Pr and Si ions as well as a small amount of cluster and molecular ions are generated by the ion source according to this aspect of the present invention. Accordingly, no impurities will be introduced into semiconductor materials when being processed with an ion beam generated by this ion source. Furthermore, Pr ions are much heavier than Si ions. Accordingly, when structuring semiconductor surfaces Pr can be used for quick surface degradation whereas the lighter Si ions can be used for fine degradation. Thus, the binary alloy PrSi allows both for fast and fine surface degradation with a single ion source. Finally, in contrast to pure Pr binary alloy PrSi is sufficiently stable when exposed to air so that the PrSi ion source can be readily manufactured and mounted.

According to an embodiment of the present invention, the emitter comprises a filament and a hairpin which are preferably made of tungsten or tantalum. The filament/hairpin is coated with a layer of silicon, the coating being preferably done by sputtering. This silicon coating improves the wetting property of the filament/hairpin material with respect to the PrSi so that the emitter is readily wetted and loaded with the PrSi source material. Especially, the temperature necessary for wetting is much lower when the silicon layer is coated on the filament/hairpin. Furthermore, the use of silicon for this coating layer ensures that no impurities are introduced in a silicon semiconductor material even when material from the coating layer is emitted.

According to another embodiment of the present invention, the silicon coating layer has a thickness in the range of 100 nm to 1500 nm. This ensures that the microstructure of the filament/hairpin is maintained. Especially, the silicon coating layer is sufficiently thin so that microgrooves formed on the filament/hairpin for transporting liquid source material to the emitter tip are not clogged. On the other hand, the silicon coating has a sufficient thickness so that the material of the filament/hairpin is completely coated and also stays coated during operation.

According to another aspect of the present invention, a method of manufacturing an emitter for an ion source is provided. According to the manufacturing method a filament/hairpin is provided, the binary alloy PrSi is provided in a molten (liquid) state, the filament/hairpin is wetted with said liquid PrSi, and finally said filament/hairpin is loaded with a droplet of said liquid PrSi.

### BRIEF DESCRIPTION OF THE DRAWINGS

Some of the above indicated and other more detailed aspects of the invention, will be described in the following description and partially illustrated with reference to the figures. Therein:
- Fig. 1: shows a characteristic curve of an emitter according to the first embodiment of the present invention.
- Fig. 2: shows the mass spectrum of the ion beam generated according to the fourth embodiment of the present invention.
- Fig. 3: shows a magnification of the lower part of the mass spectrum shown in Fig. 2.
- Fig. 4: shows a characteristic curve of an emitter according to the third embodiment of the present invention.
- Fig. 5: shows a characteristic curve of an emitter according to the fourth embodiment of the present invention.
- Fig. 6: shows an emitter of the filament and hairpin type and an emitter of the capillary type

### DETAILED DESCRIPTION OF THE DRAWINGS

### Embodiment 1

Filament and hairpin were manufactured from a tungsten wire of 0.2 mm thickness and then spot-welded to each other. The tip of the hairpin was lapped and microgrooves extending towards the tip were created for transporting liquid source material to the tip. Subsequently, a silicon coating layer of 700 nm thickness was sputtered on the filament and the hairpin.

A PrSi source material was provided with 11 % Si and 89% Pr. It was molten in high vacuum within a directly heated tantalum crucible. The eutectic PrSi alloy has a melting point of 732 °C. It is an advantage of the eutectic PrSi alloy that the melting point is lower than for all other proportions of Pr and Si. Furthermore, this proportion of Pr and Si will also be constantly maintained in the ion beam so that none of the ingredients will be completely consumed before the other.

Then, the preheated coated filament and hairpin were brought in contact with the eutectic PrSi melt. Due to cohesiveness, liquid PrSi material starts to flow onto the filment and the hairpin and, thus, a thin layer of liquid PrSi forms on the filament and the hairpin. Thus, the coated filament and hairpin are wetted with the liquid PrSi alloy. Subsequently, the wetted filament and hairpin were loaded with a droplet of liquid PrSi. Typically, the droplet has a volume of about 1 to 3 mm³. Wetting and loading can be accomplished in a range from 732°C to 1100°C.

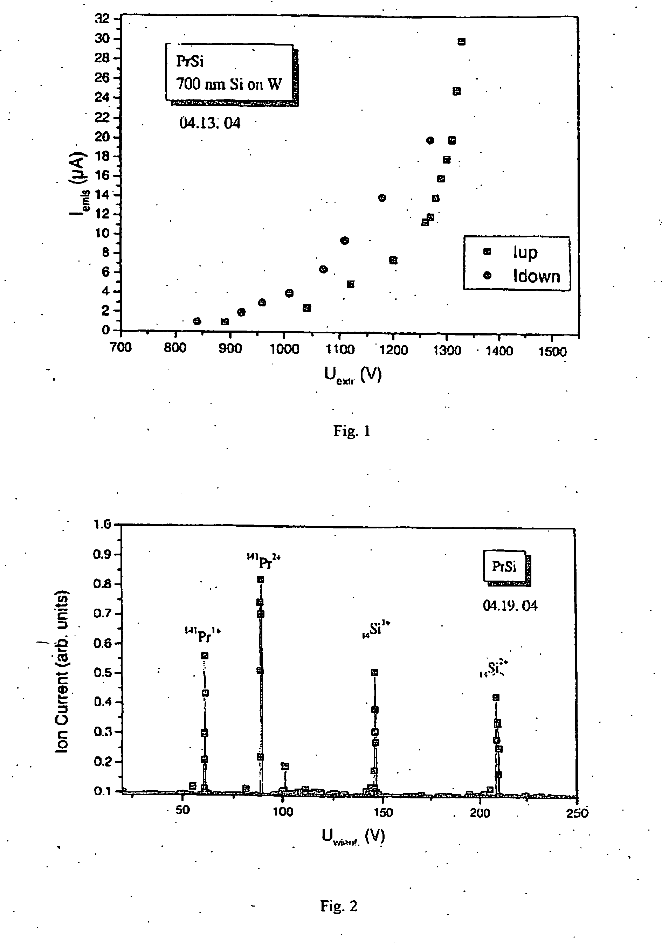

The characteristic curve of the present embodiment of the invention is shown in Fig. 1. Therein, squares indicate the beam current when the extraction voltage is increased and circles indicate the beam current when the extraction voltage is decreased.

The beam current characteristic shown in Fig. 1 is not too steep so that the beam current of the source can be effectively controlled within the range of 1 µA to 30 µA. Also, the onset voltage of the ion source is quite moderate.

Fig. 2 shows a mass spectrum of the PrSi emitter according to the present embodiment of the invention. Therein, it is shown that ¹⁴¹Pr¹⁺ and ¹⁴¹Pr²⁺ ions form the main fraction as it is expected from the proportion of Pr and Si in the binary alloy. Also, ²⁸Si¹⁺ and ²⁸Si²⁺ ions are the dominant Si ion species.

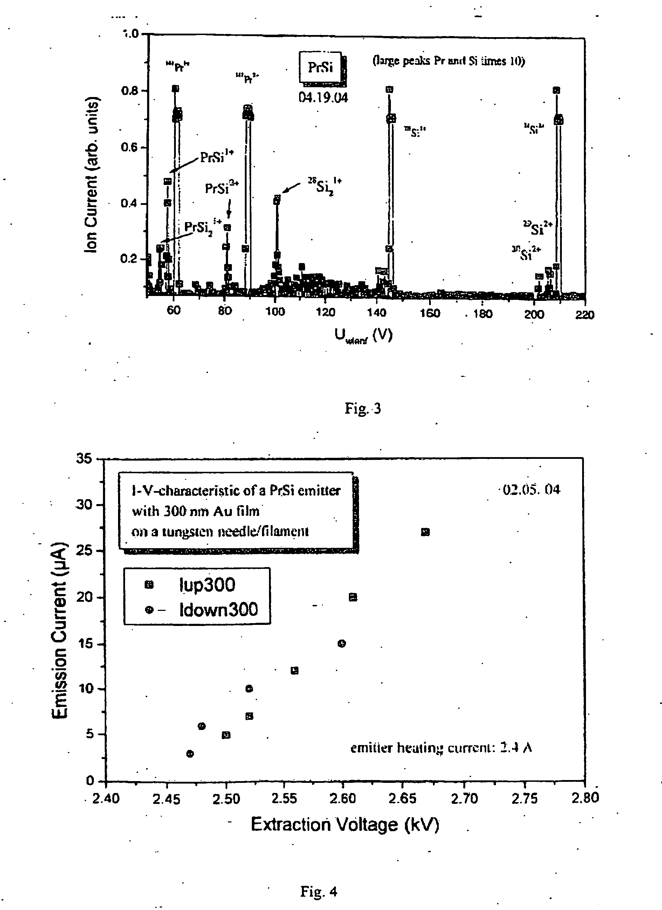

Fig. 3 shows a more differentiated analysis of the mass spectrum of Fig. 2 in that it presents an enlarged view of the smaller fractions of ion species contained in the ion beam. Therein, also the ²⁹Si²⁺ and ³⁰Si²⁺ ions of the Si line are clearly visible. Furthermore, there are ionized ²⁸Si₂¹⁺ molecules contained in the ion beam. Further to this, also PrSi¹⁺, PrSi²⁺ and even PrSi₂¹⁺ molecules are contained in the ion beam. It should be noted that only a single isotope of ¹⁴¹Pr exists.

### Embodiment 2

Filament and hairpin were manufactured from a tungsten wire of 0.2 mm thickness and then spot-welded to each other. The tip of the hairpin was lapped and microgrooves extending towards the tip were created for transporting liquid source material to the tip. Subsequently, a silicon coating layer of 500 nm thickness was sputtered on the filament/hairpin.

A PrSi source material was provided with 11% Si and 89% Pr. It was molten in high vacuum within a directly heated tungsten crucible.

Then, the preheated coated filament and hairpin were brought into contact with the eutectic PrSi melt. Due to cohesiveness, liquid PrSi material starts to flow onto the filment and the hairpin and, thus, a thin layer of liquid PrSi forms on the filament and the hairpin. Thus, the coated filament and hairpin are wetted with the liquid PrSi alloy. Subsequently, the wetted filament and hairpin were loaded with a droplet of liquid PrSi. Typically, the droplet has a volume of about 1 to 3 mm³. Wetting and loading can be accomplished in a range from 732°C to 1100°C.

The emitter was heated with a heating current of 3.0 A in a vacuum of 1·10⁻⁶ Torr. An extraction voltage in the range of 3.0 kV to 4.0 kV was applied to generate emission currents in the range of 5 µA to 30 µA. The mass spectrum of the second embodiment is almost identical to the one shown in Figs. 2 and 3.

After most of the first PrSi loading was consumed due to ion emission, a second loading of the same emitter was accomplished. The emitter was heated with a heating current of 3.2 A in a vacuum of 8·10⁻⁶ Torr. An extraction voltage in the range of 2.8 kV to 3.8 kV was applied to generate emission currents in the range of 3 µA to 20 µA. Also, the mass spectrum of the second loading is almost identical to the one shown in Figs. 2 and 3.

Thus, it was demonstrated that an emitter according to an embodiment of the present invention can be reused.

### Embodiment 3

Filament and hairpin were manufactured from a tungsten wire of 0.2 mm thickness and then spot-welded to each other. The tip of the hairpin was lapped and microgrooves extending towards the tip were created for transporting liquid source material to the tip. Subsequently, a gold coating layer of 300 nm thickness was evaporated on the filament and the hairpin.

A PrSi source material was provided with 11% Si and 89% Pr. It was molten in high vacuum within a directly heated tantalum crucible. Then, the preheated coated filament and hairpin were brought in contact with the eutectic PrSi melt. Due to cohesiveness, liquid PrSi material starts to flow onto the filment and the hairpin and, thus, a thin layer of liquid PrSi forms on the filament and the hairpin. Thus, the coated filament and hairpin are wetted with the liquid PrSi alloy. Subsequently, the wetted filament and hairpin were loaded with a droplet of liquid PrSi. Typically, the droplet has a volume of about 1 to 3 mm³. Wetting and loading can be accomplished in a range from 732°C to 1100°C.

The characteristic curve of the third embodiment of the invention is shown in Fig. 4. Therein, squares indicate the beam current when the extraction voltage is increased and circles indicate the beam current when the extraction voltage is decreased. The beam current characteristic shown in Fig. 4 is almost linear so that the beam current of the source can be effectively controlled within the range of 5 µA to 30 µA. However, the onset voltage of the ion source is higher than in the first embodiment.

### Embodiment 4

Filament and hairpin were manufactured from a tungsten wire of 0.2 mm thickness and then spot-welded to each other. The tip of the hairpin was lapped and microgrooves extending towards the tip were created for transporting liquid source material to the tip. Subsequently, a gold coating layer of 500 nm thickness was evaporated on the filament and the hairpin.

A PrSi source material was provided with 11% Si and 89% Pr. It was molten in high vacuum within a directly heated tantalum crucible. Then, the preheated coated filament and hairpin were brought in contact with the eutectic PrSi melt. Due to cohesiveness, liquid PrSi material starts to flow onto the filment and the hairpin and, thus, a thin layer of liquid PrSi forms on the filament and the hairpin. Thus, the coated filament and hairpin are wetted with the liquid PrSi alloy. Subsequently, the wetted filament and hairpin were loaded with a droplet of liquid PrSi. Typically, the droplet has a volume of about 1 to 3 mm³. Wetting and loading can be accomplished in a range from 732°C to 1100°C.

The characteristic curve of the third embodiment of the invention is shown in Fig. 5. Therein, squares indicate the beam current when the extraction voltage is increased and circles indicate the beam current when the extraction voltage is decreased. The beam current characteristic shown in Fig. 5 is not steep so that the beam current of the source can be effectively controlled within the range of 2.5 µA to 30 µA. However, the onset voltage of the ion source is higher than in the third embodiment.

## Claims

1. An emitter for an ion source, wherein said emitter comprises the binary alloy PrSi.

2. The emitter according to claim 1, wherein the PrSi binary alloy is of the form PrₓSi₁₋ₓ, x = 0.89±0.10.

3. The emitter according to-claim 1 or 2, wherein the PrSi binary alloy is eutectic.

4. The emitter according to any of the preceding claims, wherein the emitter is of the filament and hairpin type, the reservoir type with hairpin, the reservoir type without hairpin, or of the porous type.

5. The emitter according to claim 4, wherein the filament and/or the hairpin is made of tungsten, tantalum, titanium or nickel.

6. The emitter according to claim 4 or 5, wherein the filament and/or the hairpin are coated with an intermediate layer.

7. The emitter according to claim 6, wherein the intermediate layer comprises silicon as a predominant component.

8. The emitter according to claim 6, wherein the intermediate layer comprises gold as a predominant component.

9. The emitter according to claim 4, wherein the emitter is of the porous type and the granules are coated with Si or Au prior pressing.

10. The emitter according to any of claims 6 to 8, wherein the intermediate layer has a thickness in the range of 100 nm to 1500 nm.

11. The emitter according to any of claims 6 to 8 or 10, wherein the intermediate layer has a thickness of 300 nm, 500 nm or 700 nm.

12. The emitter according to any of claims 1 to 11, wherein the hairpin and the filament comprise microgrooves extending in a direction towards the needle tip.

13. The emitter according to claim 12, wherein the microgooves are generated by etching or grinding.

14. A method of producing an emitter for an ion source, comprising the steps of
providing a filament and a hairpin;
providing a melt of PrSi;
wetting said filament and hairpin with said melt of PrSi;
loading said filament and hairpin with a droplet of said melt of PrSi after said filament and hairpin have been wetted with said melt ofPrSi.

15. The method of claim 14, wherein the molten PrSi binary alloy is of the form PrₓSi₁₋ₓ, x = 0.89 ± 0.10.

16. The method according to claim 14 or 15, wherein the molten PrSi binary alloy is eutectic.

17. The method of any of claims 14 to 16, wherein the filament and the hairpin is made of tungsten, tantalum, titanium or nickel.

18. The method of any of claims 14 to 17, wherein the filament and the hairpin is coated with an intermediate layer prior to the wetting of the filament and the hairpin.

19. The method according to claim 18, wherein the intermediate layer comprises silicon or gold as a predominant component.

20. The method according to claim 19, wherein the intermediate layer has a thickness in the range of 100 nm to 1500 nm.

21. The method according to any of claims 18 to 20, wherein the intermediate layer has a thickness of 300 nm, 500 nm or 700 nm.

22. The method according to any of claims 18 to 21, wherein the material of the intermediate layer is generated on the filament and the hairpin by sputtering or evaporation.

23. The method of any of claims 14 to 22, wherein the wetting and loading of the filament and the hairpin is accomplished at temperatures in the range of 732°C to 1100°C.

## Patentansprüche

1. Emitter für eine Ionenquelle, wobei der Emitter die binäre Legierung PrSi umfaßt.

2. Emitter nach Anspruch 1, wobei die binäre Legierung PrSi die Form PrₓSi₁₋ₓ, x = 0,89±0,10, aufweist.

3. Emitter nach Anspruch 1 oder 2, wobei die binäre Legierung PrSi eutektisch ist.

4. Emitter nach einem der vorhergehenden Ansprüche, wobei der Emitter vom Filament- und-Nadel-Typ, vom Reservoirtyp mit Nadel, vom Reservoirtyp ohne Nadel oder vom porösen Typ ist.

5. Emitter nach Anspruch 4, wobei das Filament und/oder die Nadel aus Wolfram, Tantal, Titan oder Nickel hergestellt sind.

6. Emitter nach Anspruch 4 oder 5, wobei das Filament und/oder die Nadel mit einer Zwischenschicht beschichtet sind.

7. Emitter nach Anspruch 6, wobei die Zwischenschicht Silizium als überwiegenden Bestandteil aufweist.

8. Emitter nach Anspruch 6, wobei die Zwischenschicht Gold als überwiegenden Bestandteil aufweist.

9. Emitter nach Anspruch 4, wobei der Emitter vom porösen Typ ist und die Granalien vor dem Pressen mit Si oder Au beschichtet worden sind.

10. Emitter nach einem der Ansprüche 6 bis 8, wobei die Zwischenschicht eine Dicke im Bereich von 100 nm bis 1500 nm aufweist.

11. Emitter nach einem der Ansprüche 6 bis 8 oder 10, wobei die Zwischenschicht eine Dicke von 300 nm, 500 nm oder 700 nm aufweist.

12. Emitter nach einem der Ansprüche 1 bis 11, wobei die Nadel und das Filament Mikrorillen umfassen, die in einer Richtung zur Nadelspitze hin verlaufen.

13. Emitter nach Anspruch 12, wobei die Mikrorillen durch Ätzen oder Schleifen erzeugt werden.

14. Verfahren zur Herstellung eines Emitters für eine Ionenquelle, umfassend die Schritte:
Bereitstellen eines Filaments und einer Nadel;
Bereitstellen einer Schmelze von PrSi;
Benetzen des Filaments und der Nadel mit der Schmelze von PrSi;
Beladen des Filaments und der Nadel mit einem Tröpfchen der Schmelze von PrSi nachdem das Filament und die Nadel mit der Schmelze von PrSi benetzt worden sind.

15. Verfahren nach Anspruch 14, wobei die geschmolzene binäre Legierung PrSi die Form PrₓSi₁-ₓ, x = 0,89±0,10, aufweist.

16. Verfahren nach Anspruch 14 oder 15, wobei die geschmolzene binäre Legierung PrSi eutektisch ist.

17. Verfahren nach einem der Ansprüche 14 bis 16, wobei das Filament und die Nadel aus Wolfram, Tantal, Titan oder Nickel hergestellt wurden.

18. Verfahren nach einem der Ansprüche 14 bis 17, wobei das Filament und die Nadel vor dem Benetzen des Filaments und der Nadel mit einer Zwischenschicht beschichtet werden.

19. Verfahren nach Anspruch 18, wobei die Zwischenschicht Silizium oder Gold als überwiegenden Bestandteil aufweist.

20. Verfahren nach Anspruch 19, wobei die Zwischenschicht eine Dicke im Bereich von 100 nm bis 1500 nm aufweist.

21. Verfahren nach einem der Ansprüche 18 bis 20, wobei die Zwischenschicht eine Dicke von 300 nm, 500 nm oder 700 nm aufweist.

22. Verfahren nach einem der Ansprüche 18 bis 21, wobei das Material der Zwischenschicht auf dem Filament und der Nadel durch Sputtern oder Verdampfen erzeugt wird.

23. Verfahren nach einem der Ansprüche 14 bis 22, wobei das Benetzen und Beladen des Filaments und der Nadel bei Temperaturen im Bereich von 732°C bis 1100°C ausgeführt werden.

## Revendications

1. Emetteur pour une source d'ions, dans lequel ledit émetteur comprend l'alliage binaire PrSi.

2. Emetteur selon la revendication 1, dans lequel l'alliage binaire PrSi est de la forme PrₓSi₁₋ₓ, x = 0,89 ± 0,10.

3. Emetteur selon la revendication 1 ou 2, dans lequel l'alliage binaire PrSi est eutectique.

4. Emetteur selon l'une quelconque des revendications précédentes, dans lequel l'émetteur est du type à filament et épingle à cheveux, du type réservoir avec épingle à cheveux, du type réservoir sans épingle à cheveux ou du type poreux.

5. Emetteur selon la revendication 4, dans lequel le filament et/ou l'épingle à cheveux est (sont) fait(s) de tungstène, tantale, titane ou nickel.

6. Emetteur selon la revendication 4 ou 5, dans lequel le filament et/ou l'épingle à cheveux sont enrobés d'une couche intermédiaire.

7. Emetteur selon la revendication 6, dans lequel la couche intermédiaire comprend du silicium en tant que composant prédominant.

8. Emetteur selon la revendication 6, dans lequel la couche intermédiaire comprend de l'or en tant que composant prédominant.

9. Emetteur selon la revendication 4, dans lequel l'émetteur est du type poreux et les granules sont enrobés de Si ou d'Au avant pressage.

10. Emetteur selon l'une quelconque des revendications 6 à 8, dans lequel la couche intermédiaire a une épaisseur située dans la plage allant de 100 nm à 1500 nm.

11. Emetteur selon l'une quelconque des revendications 6 à 8 ou 10, dans lequel la couche intermédiaire a une épaisseur de 300 nm, 500 nm ou 700 nm.

12. Emetteur selon l'une quelconque des revendications 1 à 11, dans lequel l'épingle à cheveux et le filament comprennent des micro-gorges se prolongeant dans une direction vers la pointe de l'épingle.

13. Emetteur selon la revendication 12, dans lequel les micro-gorges sont générées par gravure ou meulage.

14. Procédé de production d'un émetteur pour une source d'ions, comprenant les étapes consistant à
fournir un filament et une épingle à cheveux ;
effectuer une fusion de PrSi ;
mouiller lesdits filament et épingle à cheveux avec ladite fusion de PrSi ;
charger lesdits filament et épingle à cheveux avec une gouttelette de ladite fusion de PrSi après avoir mouillé lesdits filament et épingle à cheveux avec ladite fusion de PrSi.

15. Procédé selon la revendication 14, dans lequel l'alliage binaire PrSi est de la forme PrₓSi₁₋ₓ, x = 0,89 ± 0,10.

16. Procédé selon la revendication 14 ou 15, dans lequel l'alliage binaire PrSi fondu est eutectique.

17. Procédé selon l'une quelconque des revendications 14 à 16, dans lequel le filament et l'épingle à cheveux sont faits de tungstène, tantale, titane ou nickel.

18. Procédé selon l'une quelconque des revendications 14 à 17, dans lequel le filament et l'épingle à cheveux sont enrobés d'une couche intermédiaire avant mouillage du filament et de l'épingle à cheveux.

19. Procédé selon la revendication 18, dans lequel la couche intermédiaire comprend du silicium ou de l'or en tant que composant prédominant.

20. Procédé selon la revendication 19, dans lequel la couche intermédiaire a une épaisseur située dans la plage allant de 100 nm à 1500 nm.

21. Procédé selon l'une quelconque des revendications 18 à 20, dans lequel la couche intermédiaire a une épaisseur de 300 nm, 500 nm ou 700 nm.

22. Procédé selon l'une quelconque des revendications 18 à 21, dans lequel le matériau de la couche intermédiaire est généré sur le filament et l'épingle à cheveux par pulvérisation ou évaporation.

23. Procédé selon l'une quelconque des revendications 14 à 22, dans lequel le mouillage et le chargement du filament et de l'épingle à cheveux sont effectués à des températures situées dans la plage allant de 732°C à 1100°C.
